**Europäisches Patentamt**

**European Patent Office**

**Office européen des brevets**

(19)

(11) Veröffentlichungsnummer: **0 213 233**
**B1**

(12) **EUROPÄISCHE PATENTSCHRIFT**

(45) Veröffentlichungstag der Patentschrift:
**25.07.90**

(51) Int. Cl.⁵: **G01R 23/15**

(21) Anmeldenummer: **85111258.1**

(22) Anmeldetag: **06.09.85**

(54) Digitalschaltung zur Frequenzbereichsklassifizierung der Frequenz eines Signals.

(43) Veröffentlichungstag der Anmeldung:
**11.03.87 Patentblatt 87/11**

(45) Bekanntmachung des Hinweises auf die Patenterteilung:
**25.07.90 Patentblatt 90/30**

(84) Benannte Vertragsstaaten:
**DE FR GB IT NL**

(56) Entgegenhaltungen:
**US-A- 3 990 007**
**US-A- 4 326 256**

**ELECTRONIC DESIGN, Band 30, Nr. 9, April 1982, Seiten 215-216, WASECA, MN, DENVILLE, NJ, US; J.P. OEHICHEN: "Two-chip discriminator monitors frequency window"**

(73) Patentinhaber: **Deutsche ITT Industries GmbH, Hans-Bunte-Strasse 19 Postfach 840, D-7800 Freiburg(DE)**

(72) Erfinder: **Mehrgardt, Sönke, Dr., Häglestrasse 26, D-7801 March(DE)**

## Beschreibung

Die Erfindung betrifft eine Digitalschaltung zur Klassifizierung der Frequenz eines Signals in mindestens zwei nichtüberlappende Frequenzbereiche unter Verwendung der variablen Frequenz eines Taktsignals als Meßreferenz.

In der Elektronik gibt es das Bedürfnis, die variable Frequenz eines Signals anstatt zu messen und somit den genauen Zahlenwert festzustellen, lediglich in Frequenzbereiche zu klassifizieren und ein Digitalsignal zu erzeugen, dessen einem Pegel die Information zugeordnet ist, daß die Frequenz im zugeordneten Frequenzbereich liegt.

Aus der US-Patentschrift US-A 3 990 007 ist eine Digitalschaltung zur Klassifizierung der Frequenz eines Signals in mindestens zwei nichtüberlappende Frequenzbereiche bekannt. Sie enthält einen Vorwärtszähler, dessen Takteingang über einen programmierbaren Frequenzteiler mit dem zu klassifizierenden Signal gespeist ist und dessen Reseteingang ein Torsignal aus einer Zeitbildungsstufe zugeführt ist. Die Zeitbildungsstufe enthält drei monostabile Multivibratoren, welche drei Zeitfenster für die Meßzeit bilden. Zwei der monostabilen Multivibratoren sind digital programmierbar und bestimmen ein unteres bzw. ein oberes Toleranzfenster, während der dritte monostabile Multivibrator ein längeres festes Grundfenster zur Messung einer Bezugsfrequenz bildet. Der zu klassifizierende Frequenzbereich ist somit durch die Bezugsfrequenz mit anschließendem oberen und unteren Toleranzbereich definiert. Über drei Ausgangsleitungen einer Pufferschaltung wird angegeben, ob die zu klassifizierende Frequenz über, unter oder innerhalb dieses Frequenzbereichs liegt.

Bei der bekannten Digitalschaltung sind alle Parallelausgänge des Vorwärtszählers, es handelt sich dabei um einen binärcodierten Dekadenzähler, auf die Paralleleingänge eines digital programmierbaren Einfachkomparators geschaltet, der je nach dem Vergleichswert ein "größer-als" – oder ein "kleiner-als"-Signal an die Pufferschaltung weitergibt. Diese Signale werden dort mittels zweier JK-Flip-Flops, die als D-Flip-Flops geschaltet sind, gespeichert. Deren Takteingang ist vom ersten bzw. zweiten monostabilen Multivibrator in der Zeitbildungsstufe gesteuert. Da die Übernahme der beiden JK-Flip-Flops auf diese Weise nicht gleichzeitig erfolgen kann, aus der zeitlichen Umschaltfolge mittels eines an die JK-Flip-Flop-Ausgänge angeschlossenen NOR-Gatters das "in-Frequenz"-Signal abgeleitet, das angibt, daß die zu messende Frequenz innerhalb des vorgegebenen Frequenzbereiches liegt.

Die in den Ansprüchen definierte Erfindung löst die Aufgabe, eine Digitalschaltung unter Verwendung der variablen Frequenz eines Taktsignals als Meßreferenz anzugeben. Ein besonderer Anwendungsfall der Erfindung ist z.B. ein Fernsehempfänger mit digitaler Signalverarbeitung, dessen Horizontal-Ablenkfrequenz nicht gleich der einer üblichen Fernsehnorm ist, sondern auch deren 1,5- oder zweifachen Wert annehmen kann. Diese drei Frequenzwerte für die Horizontalablenkfrequenz können beispielsweise von einem Videorekorder, der solch unterschiedlichen Horizontalablenkfrequenzen zugeordnete Bildsignale gespeichert hat, an den Fernsehempfänger abgegeben werden. Dieser muß dann mit der erfindungsgemäßen Digitalschaltung die unterschiedlichen Horizontalablenkfrequenzen störungsfrei "erkennen". Dies soll auch dann noch sicher vor sich gehen, wenn die Meßreferenz dienende Frequenz des Taktsignals nicht konstant ist, sondern im betrachteten Anmeldungsfall beispielsweise zwischen 12 und 15 MHz variiert.

Die Erfindung wird nun anhand der Figuren der Zeichnung näher erläutert.

Fig. 1 zeigt das Blockschaltbild einer Ausführungsform der Erfindung,

Fig. 2 zeigt eine teilweise Vereinfachung der Anordnung nach Fig. 1 für drei nichtüberlappende Frequenzbereiche,

Fig. 3 zeigt das Blockschaltbild einer Ausführungsform für die erwähnte Fernseh-Anwendung.

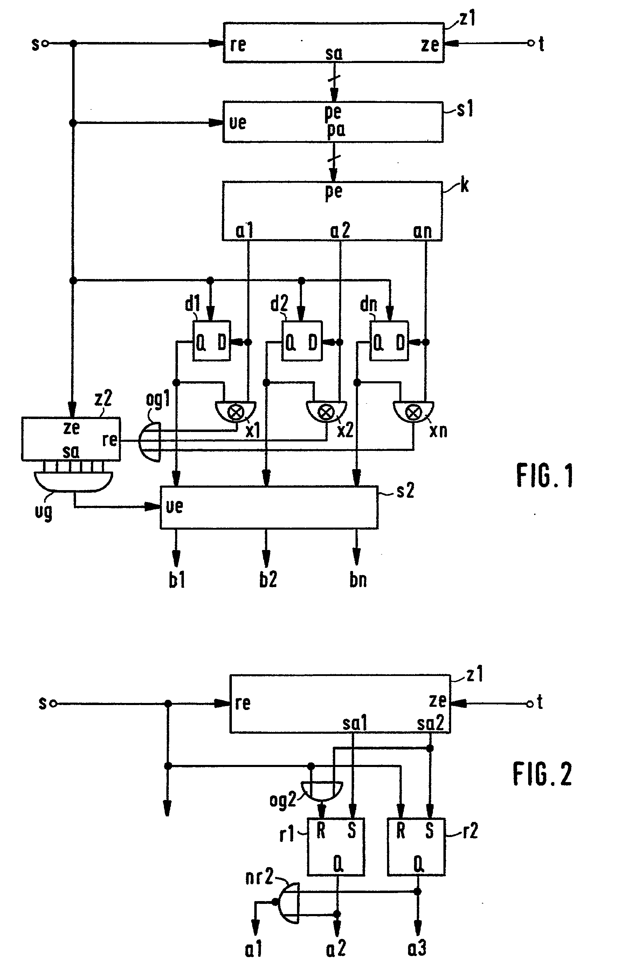

Das zu einem allgemeinen Ausführungsbeispiel gehörende Blockschaltbild der Fig. 1 zeigt den Vorwärtszähler z1, dessen Zähleingang ze das Taktsignal t und dessen Reset-Eingang re das Signal s zugeführt ist. Dieses liegt auch am Übernahmeeingang ue des ersten Pufferspeichers s1, d.h. also an demjenigen Eingang, der bei Aktivierung die Übernahme des an seinen Paralleleingängen pe liegenden Signals in die Speicherzellen freigibt. Diese Eingänge liegen an den Zählerstandausgängen sa des ersten Vorwärtszählers z1, während die Parallelausgänge pa des ersten Pufferspeichers s1 mit den Paralleleingängen pe des Mehrfachkomparators k verbunden sind. Bei ihm sind jedem nichtüberlappenden Frequenzbereich der digitale Ausgang a1 bzw. a2 bzw. an zugeordnet.

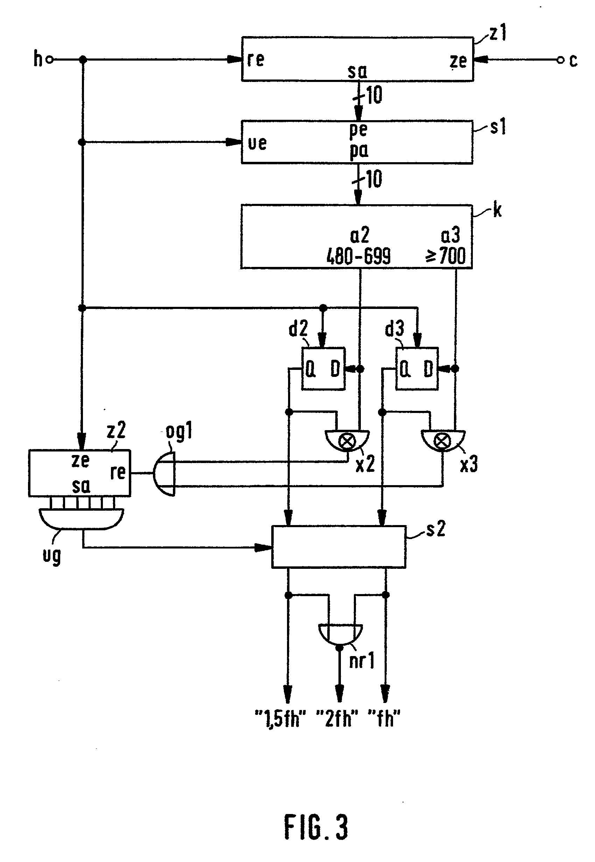

Der Mehrfachkomparator k kann auch als Fensterkomparator betrachtet werden, der an jedem seiner Ausgänge a1, a2, an ein Digitalsignal abgibt, dessen einer Pegel die Bedeutung hat, daß der Zählerstand des Vorwärtszählers z1 im jeweils zugeordneten Zahlenbereich liegt (vergl. die Fig. 3, worin dem Ausgang a2 z.B. der Zahlenbereich 480 bis 699 zugeordnet ist).

Der jeweilige Ausgang a1, a2, an ist jeweils mit dem D-Eingang D des vom Signal s getakteten D-Flipflops d1, d2, dn und mit dem ersten Eingang des jeweiligen EXOR-Gatters x1, x2, xn verbunden. Am jeweiligen zweiten Eingang der EXOR-Gatter x1, x2, xn liegt der Q-Ausgang des jeweiligen D-Flipflops d1, d2, dn.

Der jeweilige Ausgang dieser EXOR-Gatter ist jeweils mit einem Eingang des ersten ODER-Gatters og1 verbunden, dessen Ausgang am Reset-Eingang re des zweiten Vorwärtszählers z2 angeschlossen ist, dessen Zähleingang ze das Signal s zugeführt ist. Alle Zählerstandausgänge sa des zweiten Vorwärtszählers z2 liegen einzeln an je einem Eingang des UND-Gatters ug, dessen Ausgang mit dem Übernahmeeingang ue des zweiten Pufferspeichers s2 verbunden ist, von dem je ein Eingang am Q-Ausgang je eines der D-Flipflops d1, d2, dn angeschlossen ist und von dem der jeweilige Ausgang b1, b2, bn der jeweilige Frequenzbereichsausgang der Digitalschaltung ist.

Die positive Flanke eines Signalimpulses des Signals s setzt den ersten Vorwärtszähler z1 zurück, und zugleich wird dessen zu diesem Zeitpunkt erreichter Zählerstand in den ersten Pufferspeicher s1 übernommen, so daß mittels des Mehrfachkomparators k die erwähnte Zahlenwert-Bereichs klassifikation erfolgen kann. Der zweite Vorwärtszähler z2 wird immer dann zurückgesetzt, wenn sich zwischen zwei aufeinanderfolgenden Impulsen des Signals s der Ausgangszustand des Mehrfachkomparators k ändert, also z.B. von HLL in LHL übergegangen ist. Wenn der zweite Vorwärtszähler z2 "voll" ist, also bei der vorausgesetzten positiven Logik alle seine Zählerstandausgänge sa den H-Pegel aufweisen, wird durch die Aktivierung des Übernahmeeingangs des zweiten Pufferspeichers s2 über das UND-Gatter ug der zu diesem Zeitpunkt im Mehrfachkomparator k vorhandene Zustand in den Pufferspeicher s2 übernommen. Dieser Zustand wird erst dann geändert, wenn sooft, wie der Zählkapazität des zweiten Vorwärtszählers z2 entspricht, der Ausgangszustand des Mehrfachkomparators k unverändert geblieben ist. Wenn der Vorwärtszähler z2 also beispielsweise ein sechsstufiger Binärzähler ist, so muß während $2^6 = 64$ Impulsen des Signals der Ausgangszustand des Mehrfachkomparators k unverändert bleiben.

Die Fig. 2 zeigt eine vorteilhafte Vereinfachung für den ersten Pufferspeicher s1 und den Mehrfachkomparator k, wenn drei nichtüberlappende Frequenzbereiche vorgegeben sind. Die Teilschaltungen s1, k sind mittels des zweiten ODER-Gatters og2, des ersten und des zweites RS-Flipflops r1, r2 und des zweiten NOR-Gatters nr2 realisiert. Am jeweiligen Zählerstandausgang sa1, sa2 der ersten bzw. zweiten Frequenzbereichs-Obergrenze liegt der S-Eingang des jeweiligen RS-Flipflops r1, r2. Von den beiden Eingängen des zweiten ODER-Gatters og2 ist dem einen zusammen mit dem R-Eingang des zweiten RS-Flipflops r2 das Signal s zugeführt bzw. der andere mit dem Zählerstandausgang sa2 der zweiten Frequenzbereichsobergrenze verbunden. Der R-Eingang des ersten RS-Flipflops r1 liegt am Ausgang des zweiten ODER-Gatters og2. Der jeweilige Q-Ausgang der RS-Flipflops r1, r2 liegt an jeweils einem der beiden Eingänge des zweiten NOR-Gatters nr2, dessen Ausgang dem ersten Ausgang a1 des Mehrfachkomparators k entspricht, während dessen zweiter bzw. dritter Ausgang a2, a3 durch den jeweiligen Q-Ausgang des ersten bzw. zweiten RS-Flipflops r1, r2 gebildet wird.

In Fig. 3 ist für die eingangs erwähnte bevorzugte Anwendung das entsprechende Blockschaltbild gezeigt. Als Signal s nach Fig. 1 und 2 dienen die Horizontalsynchronimpulse h und als Taktsignal t der Systemtakt c eines Fernsehempfängers mit digitaler Signalverarbeitung. Die Vorwärtszähler z1, z2 haben eine Zählkapazität von $2^{10}$ bzw. $2^6$, was im ersteren Fall durch die Zahl 10 am Querstrich der Verbindungsleitungen zwischen erstem Vorwärtszähler z1 und erstem Pufferspeicher s1 bzw. diesem und Mehrfachkomparator k angedeutet ist. Es sind die drei Frequenzbereiche null bis fh, fh bis 1,5 fh und 1,5 fh bis 2 fh vorgesehen, wobei fh die Horizontalsynchronfrequenz ist.

Der erste digitale Ausgang a1 des Mehrfachkomparators k nach Fig. 1 und 2 ist nicht benutzt, und anstatt des ersten D-Flipflops d1 und des ertsten EXOR-Gatter x1 nach Fig. 1 ist das erste NOR-Gatter nr1 vorgesehen. Von seinen beiden Eingängen liegt jeweils einer an je einem Ausgang des zweiten Pufferspeichers s2, an denen die Signale "fh", "1,5fh" abzugreifen sind, während das Signal "2 fh" am Ausgang des ersten NOR-Gatters nr1 abgreifbar ist.

Wenn die Anordnung nach Fig. 3 für einen Fernsehempfänger nach dem NTSC-Fernseh-Standard vorgesehen ist, so ist der zweite Ausgang a2 des Mehrfachkomparators k den Zahlenwerten 480 bis 699 sowie dessen dritter Ausgang a3 den Zahlenwerten, die gleich oder größer 700 sind, zugeordnet.

Mit der Digitalschaltung der Erfindung ist die störungsfreie Klassifizierung der Frequenz des Signals s, insbesondere der Horizontalsynchronimpulse h, möglich. Die Digitalschaltung läßt sich ohne weiteres halbleitertechnisch integrieren und kann beispielsweise in eine bereits vorhandene oder zu konzipierende größere integrierte Schaltung einbezogen werden. Zur Realisierung eignet sich insbesondere die Technik integrierter Isolierschicht-Feldeffekttransistor-Schaltungen, also die sogenannte MOS-Technik.

**Patentansprüche**

1. Digitalschaltung zur Klassifizierung der Frequenz eines Signals (s) in mindestens zwei nichtüberlappende Frequenzbereiche unter Verwendung der variablen Frequenz eines Taktsignals (t) als Meßreferenz, wobei
- das Taktsignal (t) dem Zähleingang (ze) eines ersten Vorwärtszählers (z1) und das Signal (s) dessen Reset-Eingang (re) zugeführt ist, das auch am Übernahme-Eingang (ue) eines ersten Pufferspeichers (s1) liegt,
- die Paralleleingänge (pe) des ersten Pufferspeichers (s1) mit den Zählerstandausgängen (sa) des ersten Vorwärtszählers (z1) und die Parallelausgänge (pa) des ersten Pufferspeichers (s1) mit den Paralleleingängen (pe) eines Mehrfachkomparators (k) verbunden sind, bei dem jedem nichtüberlappenden Frequenzbereich ein digitaler Ausgang (a1, a2, an) zugeordnet ist,
- der jeweilige digitale Ausgang ($a_1$, $a_2$, $a_n$) jeweils mit dem D-Eingang (D) eines vom Signal (s) getakteten D-Flipflops (d1, d2, dn) und mit dem ersten Eingang eines EXOR-Gatters (x1, x2, xn) verbunden ist, an dessen zweitem Eingang der Q-Ausgang des entsprechenden D-Flipflops (d1, d2, dn) liegt,
- dem Zähleingang (ze) eines zweiten Vorwärtszählers (z2) das Signal (s) zugeführt ist und sein Reset-Eingang (re) am Ausgang eines ersten ODER-Gatters (og1) liegt, von dem je ein Eingang mit dem Ausgang je eines der EXOR-Gatter (x1, x2, xn) verbunden ist, und
- je ein Zählerstandausgang (sa) des zweiten Vorwärtszählers (z2) an je einem Eingang eines UND-Gatters (ug) liegt, dessen Ausgang mit dem Übernahme-Eingang (ue) eines zweiten Pufferspeichers (s2) verbunden ist, von dem je ein Eingang am Q-Ausgang je eines der D-Flipflops (d1, d2, dn) angeschlossen ist und von dem der jeweilige Ausgang (b1, b2, bn) der jeweilige Frequenzbereichsausgang der Digitalschaltung ist.

2. Digitalschaltung nach Anspruch 1, gekennzeichnet durch folgende Merkmale:
- als Signal (s) dienen die Horizontalsynchronimpulse (h) und als Taktsignal (t) der Systemtakt (c) eines Fernsehempfängers mit digitaler Signalverarbeitung,
- der erste Vorwärtszähler (z1) hat eine Zählkapazi-tät von $2^{10}$ und der zweite (z2) von $2^6$,
- es sind die drei Frequenzbereiche null bis fh, fh bis 1,5 fh und 1,5 fh bis 2 fh vorgesehen, wobei fh die Horizontalfrequenz ist,
- der erste digitale Ausgang des Mehrfachkomparators (k) ist nicht benutzt,
- anstatt des ersten D-Flipflops (d1) und des ersten EXOR-Gatters (x1) ist ein erstes NOR-Gatter (nr1) vorgesehen, von dessen beiden Eingängen jeweils einer an je einem Ausgang des zweiten Pufferspeichers (s2) liegt, an denen die Signale "fh", "1,5 fh" abzugreifen sind, und
- das Signal "2 fh" ist am Ausgang des ersten NOR-Gatters (nr1) abzugreifen.

3. Digitalschaltung nach Anspruch 2, dadurch gekennzeichnet, daß beim NTSC-Fernseh-Standard der zweite Ausgang (a2) des Mehrfachkomparators (k) den Zahlenwerten 480 bis 699 sowie dessen dritter als letzter Ausgang (a3) den Zahlenwerten, die gleich oder größer 700 sind, zugeordnet ist.

4. Digitalschaltung für drei nichtüberlappende Frequenzbereiche nach einem der Ansprüche 1 bis 3, dadurch gekennzeichnet, daß der erste Pufferspeicher (s1) und der Mehrfachkomparator (k) wie folgt realisiert sind:
- am jeweiligen Zählerstandausgang (sa1, sa2) der ersten bzw. zweiten Frequenzbereichs-Obergrenze liegt der S-Eingang eines ersten bzw. zweiten RS-Flipflops (r1, r2),
- von den beiden Eingängen eines zweiten ODER-Gatters (og2) ist dem einen zusammen mit dem R-Eingang des zweiten RS-Flipflops (r2) das Signal (s) zugeführt bzw. der andere mit dem Zählerstandausgang (sa2) der zweiten Frequenzbereichs-Obergrenze verbunden,
- der R-Eingang des ersten RS-Flipflops (r1) liegt am Ausgang des zweiten ODER-Gatters (og2), und
- der Q-Ausgang des ersten bzw. zweiten RS-Flipflops (r1, r2) liegt an jeweils einem der beiden Eingänge eines zweiten NOR-Gatters (nr2), dessen Ausgang dem ersten Ausgang (a1) des Mehrfachkomparators (k) entspricht, während dessen zweiter bzw. dritter Ausgang (a2, a3) durch den jeweiligen Q-Ausgang des ersten bzw. zweiten RS-Flipflops (r1, r2) gebildet wird (Fig. 2).

**Claims**

1. Digital circuit for classifying the frequency of a signal (s) in at least two nonoverlapping frequency ranges using the variable frequency of a clock signal (t) as a reference, wherein
- the clock signal (t) is applied to the count input (ze) of a first up counter (z1), and the signal (s) to the reset input (re) of said counter and to the enable input (us) of a first buffer (s1);
- the parallel inputs (pe) of the first buffer (s1) are connected to the count outputs (sa) of the first up counter (z1), and the parallel outputs (pa) of the first buffer (s1) to the parallel inputs (pe) of a multiple comparator (k) in which each nonoverlapping frequency range is assigned a digital output (a1, a2, an);
- each of the digital outputs (a1, a2, an) is connected to the D input (D) of a D flip-flop (d1, d2, dn) clocked by the signal (s) and to the first input of an EXOR gate (x1, x2, xn) having its second input connected to the Q output of the associated D flip-flop (d1, d2, dn);
- the signal (s) is applied to the count output (ze) of a second up counter (z2) whose reset input (re) is connected to the output of a first OR gate (og1) having each of its inputs connected to the output of one of the EXOR gates (x1, x2, xn), and
- each of the count outputs (sa) of the second up counter (z2) is coupled to one of the inputs of an AND gate (ug) having its output connected to the enable input (ue) of a second buffer (s2) each of whose inputs is connected to the Q output of one of the D flip-flops (d1, d2, dn), and whose outputs (b1, b2, bn) are the frequency-range outputs of the digital circuit.

2. A digital circuit as claimed in claim 1, characterized by the following features:
- The signal (s) and the clock signal (t) are, respectively, the horizontal synchronizing pulses (h) and the system clock (c) of a television receiver with digital signal-processing circuitry;
- the first up counter (z1) has a capacity of $2^{10}$, and the second (z2) a capacity of $2^6$;
- there are provided three frequency ranges, zero to fh, fh to 1.5 fh, and 1.5 fh to 2 fh, where fh is the horizontal frequency;
- the first digital output of the multiple comparator (k) is not used;
- instead of the first D flip-flop (d1) and the first EXOR gate (x1), there is provided a first NOR gate (nr1) having each of its two inputs connected to one of the outputs of the second buffer (s2), which provide the signals "fh" and "1.5 fh", respectively, and
- the signal "2 fh" appears at the output of the first NOR gate (nr1).

3. A digital circuit as claimed in claim 2, characterized in that, in the NTSC television standard, the second output (a2) of the multiple comparator (k) is assigned to the numerical values 480 to 699, and the third output (a3), representing the last output, to the numerical values equal to or greater than 700.

4. A digital circuit as claimed in any one of claims 1 to 3 for three nonoverlapping frequency ranges, characterized in that the first buffer (s1) and the multiple comparator (k) are implemented as follows:
- The count output (sa1) for the upper limit of the first frequency range is coupled to the S input of a first RS flip-flop (r1), and the count output (sa2) for the upper limit of the second frequency range to the S input of a second RS flip-flop (r2);

– one of the two inputs of a second OR gate (og2) and the R input of the second RS flip-flop (r2) are fed with the signal (s), and the other input of the second OR gate (og2) is connected to the count output (sa2) for the upper limit of the second frequency range;

– the R input of the first RS flip-flop (a1) is connected to the output of the second OR gate (og2), and

– the Q outputs of the first and second RS flip-flops (r1, r2) are each connected to one of the two inputs of a second NOR gate (nr2), the output of which corresponds to the first output (a1) of the multiple comparator (k), while the second and third outputs (a2, a3) of the multiple comparator (k) are formed by the Q outputs of the first RS flip-flop (r1) and the second RS flip-flop (r2), respectively.

**Revendications**

1. Circuit numérique servant à classer la fréquence d'un signal (s) dans au moins deux gammes de fréquences ne se chevauchant pas, moyennant l'utilisation de la fréquence variable d'un signal de cadence (t) en tant que référence de mesure, et dans lequel

– le signal de cadence (t) est envoyé à l'entrée de comptage (ze) d'un compteur progressif (Zl) et le signal (s) est envoyé à l'entrée de remise à zéro (re) de ce compteur, ce signal étant également appliqué à l'entrée de transfert (ue) d'une mémoire tampon (s1),

– les entrées parallèles (pe) de la première mémoire tampon (s1) sont reliées aux sorties (sa) de comptage du premier compteur progressif (zl) et les sorties parallèles (pa) de la première mémoire tampon (s1) sont reliées aux entrées parallèles (pe) d'un comparateur multiple (k), dans lequel une sortie numérique (a1, a2, an) est associée à chaque gamme de fréquences non en chevauchement,

– la sortie numérique respective (a1, a2, an) est raccordée à l'entrée D (D) d'une bascule bistable de type D (d1, d2, dn) commandée de façon cadencée par le signal (s), et à la première entrée d'une porte OU-EXCLUSIF (x1, x2, xn), à la seconde entrée de laquelle est raccordée la sortie Q de la bascule bistable de type D correspondante (d1, d2, dn),

– le signal (s) est envoyé à l'entrée de comptage (ze) d'un second compteur progressif (z2) dont entrée de remise à zéro (re) est raccordée à la sortie d'une première porte OU (og1), dont chacune des entrées est raccordée à la sortie de l'une des portes OU-EXCLUSIF (x1, x2, xn), et

– chacune des sorties (sa) de comptage du second compteur progressif (z2) est raccordée à une entrée d'une porte ET (ug), dont la sortie est reliée à l'entrée de transfert (ue) d'une seconde mémoire tampon (s2), dont chacune des entrées est raccordée à la sortie Q de l'une des bascules bistables de type D (d1, d2, dn), et dont les sorties (b1, b2, bn) constituent les sorties de gammes de fréquence du circuit numérique.

2. Circuit numérique suivant la revendication 1, caractérisé par les caractéristiques suivantes:

– comme signal (s) on utilise des impulsions de synchronisation horizontale (h) et comme signal de cadence (t) on utilise la cadence système (c) d'un récepteur de télévision à un circuit ou traitement numérique des signaux,

– le premier compteur progressif (z1) possède une capacité de $2^{10}$ et le second (z2), une capacité de $2^6$,

– on prévoit les trois gammes de fréquences allant de zéro à fh, de fh à 1,5 fh et de 1,5 fh à 2 fh, fh étant la fréquence horizontale,

– la première sortie numérique du comparateur multiple (k) n'est pas utilisée,

– à la place de la première bascule bistable de type D (d1) et de la première porte OU-EXCLUSIF (x1), on prévoit une première porte NON-OU (nr1), dont chacune des deux entrées est raccordée à une sortie de la seconde mémoire tampon (s2), les signaux "fh", "1,5 fh" pouvant être prélevés sur ces sorties, et

– le signal "2 fh" peut être prélevé sur la sortie de la première porte NON-OU (nr1).

3. Circuit numérique selon la revendication 2, caractérisé en ce que, dans le cas de la norme de télévision NTSC, la seconde sortie (a2) du comparateur multiple (k) est associée aux nombres 480 à 699 et la troisième sortie constituant la dernière sortie (a3) du comparateur est associée aux nombres égaux ou supérieurs à 700.

4. Circuit numérique pour trois gammes de fréquences non en chevauchement selon l'une quelconque des revendications 1 à 3, caractérisé en ce que la première mémoire tampon (s1) et le comparateur multiple (k) sont réalisés comme suit:

– l'entrée S d'une première ou d'une seconde bascule bistable de type RS (r1, r2) est raccordée à la sortie respective (sa1, sa2) de comptage de la première ou de la seconde limite supérieure de la gamme de fréquences,

– le signal (s) est envoyé à l'une des deux entrées d'une seconde porte OU (og2) ainsi qu'à l'entrée R de la seconde bascule bistable de type RS (r2) et l'autre de ces deux entrées est reliée à la sortie (sa2) de comptage de la seconde limite supérieure de la gamme de fréquences,

– l'entrée R de la première bascule bistable de type RS (r1) est raccordée à la sortie de la seconde porte OU (og2), et

– la sortie Q des première et seconde bascules bistables de type RS (r1, r2) est raccordée à l'une respective des deux entrées d'une seconde porte NON-OU (nr2), dont la sortie correspond à la première sortie (a1) du comparateur multiple (k), tandis que la seconde ou la troisième sortie (a2, a3) est formée par la sortie Q respective de la première ou de la seconde bascule bistable de type RS (r1, r2).

FIG.1

FIG.2

FIG. 3